# EUROPEAN PATENT APPLICATION

(11) **EP 4 134 734 A1**
(43) Date of publication of application: **15.02.2023**
(21) Application number: 21190842.1
(22) Date of filing: 11.08.2021
(51) Int. Cl.: G02F 1/35, G02F 1/383, G03F 7/20

(54) **AN ILLUMINATION SOURCE AND ASSOCIATED METHOD APPARATUS**

(71) Applicant: ASML Netherlands B.V., 5500 AH Veldhoven (NL)
(72) Inventor: DONDERS, Sjoerd, Nicolaas, Lambertus, 5500 AH Veldhoven (NL); SMORENBURG, Petrus, Wilhelmus, 5500 AH Veldhoven (NL)
(74) Representative: ASML Netherlands B.V.

(57) **Abstract**

An assembly for receiving a pump radiation to interact with a gas medium at an interaction space to generate an emitted radiation. The assembly comprising: an object with a hollow core, wherein the hollow core has an elongated volume through the object, wherein the interaction space is located inside the hollow core, and a heat conductive structure that connects at multiple locations of an outside wall of the object for transferring heat generated at the interaction space away from the object.

## Description

### FIELD

The present invention relates to an illumination source and associated method and apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

### SUMMARY

In a first aspect of the invention, there is provided an assembly for receiving a pump radiation to interact with a gas medium at an interaction space to generate an emitted radiation. The assembly comprising: an object with a hollow core, wherein the hollow core has an elongated volume through the object, wherein the interaction space is located inside the hollow core, and a heat conductive structure that connects at multiple locations of an outside wall of the object for transferring heat generated at the interaction space away from the object.

In a second aspect of the invention, there is provided a radiation source comprising an assembly as described above.

In a third aspect of the invention, there is provided a lithographic apparatus comprising a radiation source as described above.

In a fourth aspect of the invention, there is provided a metrology apparatus comprising a radiation source as described above.

In a fifth aspect of the invention, there is provided a lithographic cell comprising a radiation source as described above.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a schematic drawing of a gas nozzle illumination source;
- Figure 8 depicts a schematic drawing of a capillary illumination source;
- Figure 9 depicts a schematic drawing of a cell illumination source;
- Figure 10 depicts a schematic drawing of an example of a first embodiment;
- Figure 11 depicts a schematic drawing of an example of a second embodiment;
- Figure 12 depicts a schematic drawing of an example of a third embodiment;
- Figure 13 depicts a schematic drawing of an example of a fourth embodiment.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

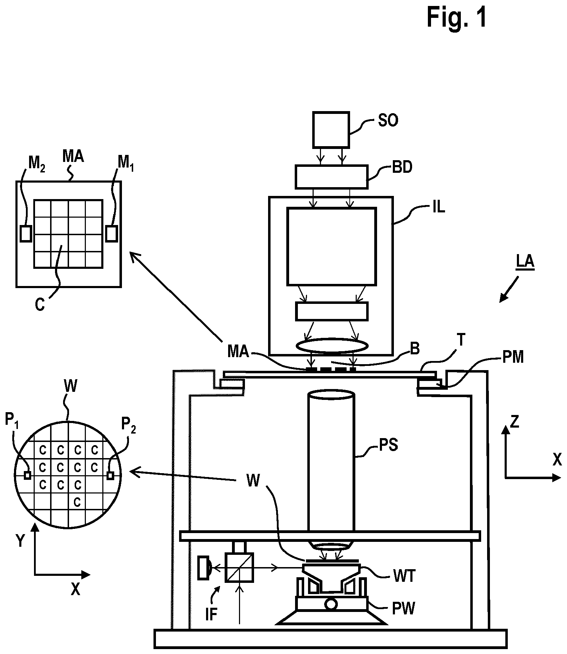

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

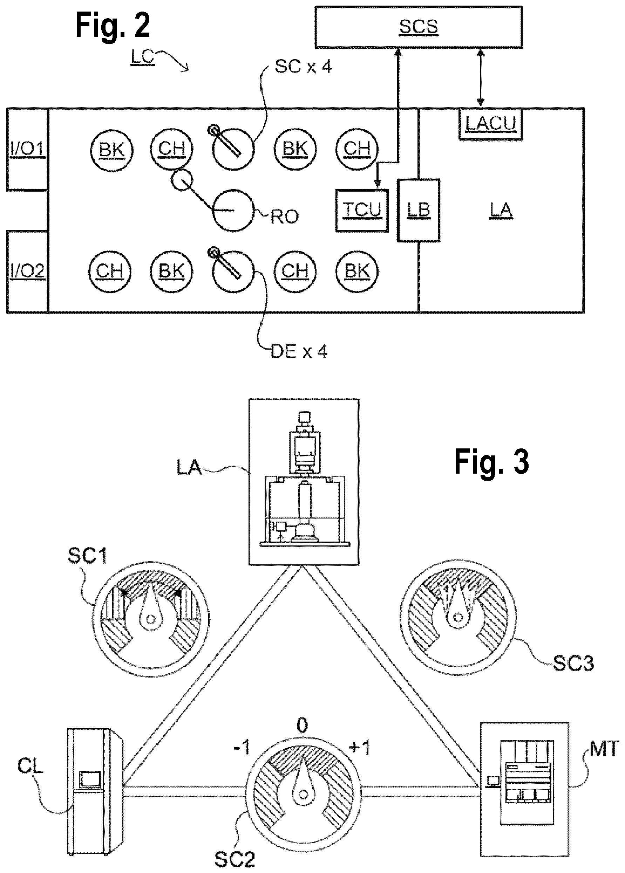

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

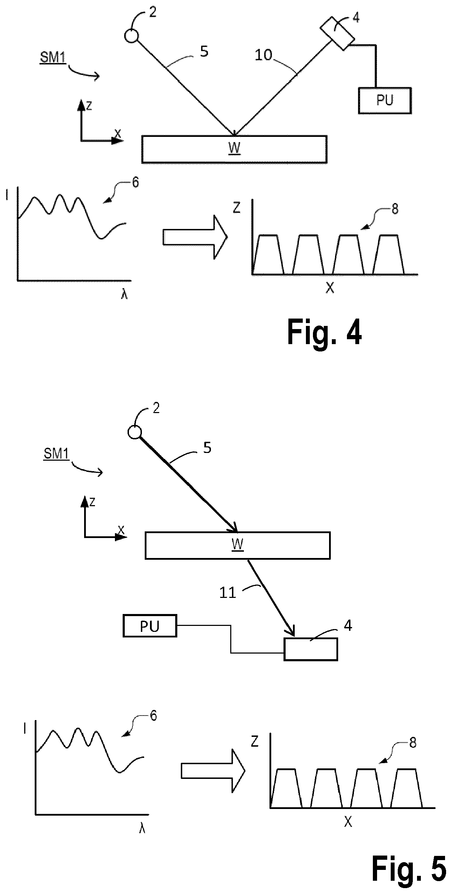

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1 nm, optionally <0.1 nm, optionally <0.01 nm.

As an alternative to optical metrology methods, it has also been considered to use hard X-ray, soft X-rays or EUV radiation, for example radiation with at least one of the wavelength ranges: <0.01 nm, <0.1 nm, <1 nm, between 0.01 nm and 100 nm, between 0.01 nm and 50 nm, between lnm and 50 nm, between 1 nm and 20 nm, between 5 nm and 20 nm, and between 10 nm and 20 nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

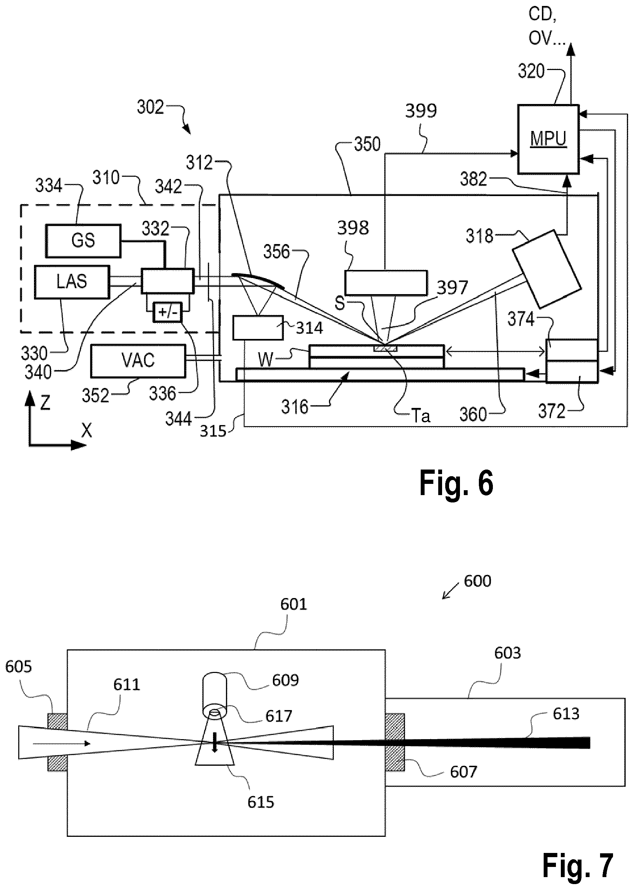

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The pump radiation comprises radiation with one or more wavelengths in a range of 200 nm to 10 µm, optionally 500 nm to 2000 nm, optionally 800 nm to 1500 nm, for example in the region of 1 µm (1 micron). Optionally, the laser pulses are delivered as a first pump radiation 340 to the gas delivery system 332, where in the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide (CO₂) and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by a vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 310 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the lithographic cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or inverse Compton scattering (ICS) to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (e.g., air, Neon (Ne), Helium (He), Nitrogen (N2), Oxygen (O₂), Argon (Ar), Krypton (Kr), Xenon (Xe), Carbon dioxide (CO₂) and the combination of two or more of them) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of the emitted radiation 613. The region where at least a majority of the emitted radiation 613 is generated is called an interaction space. The interaction space may vary from several tens of micrometres (for tightly focused pump radiation) to several mm or cm (for moderately focused pump radiation) or even up to a few meters (for extremely loosely focused pump radiation). The gas delivery system is configured to provide the gas target for generating the emitted radiation at the interaction space of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. Optionally there is a gas catcher close to the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the pump radiation 611. The emitted radiation 613 may comprise radiation with one or more wavelengths in X-ray or EUV range, wherein the wavelength is in a range from 0.01 nm to 100 nm, optionally from 0.1 nm to 100 nm, optionally from 1 nm to 100 nm, optionally from 1 nm to 50 nm, optionally from 10 nm to 50 nm and optionally from 10 nm to 20 nm. The pump radiation and the emitted radiation may have non-overlapping wavelengths.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al), Silicon (Si) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. Optionally the pump radiation comprises one or more of the following wavelengths: 1064 nm, 1080 nm and 1032 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV, SXR and/or HXR radiation, may also penetrate deeper into a material such as a patterned substrate, meaning that metrology of deeper layers on the substrate is possible. These deeper layers may not be accessible by radiation with longer wavelengths, for example visible wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected (0th order diffracted radiation) or transmitted radiation. Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be scattered from the target, detected and processed, for example to measure and/or infer properties of the target.

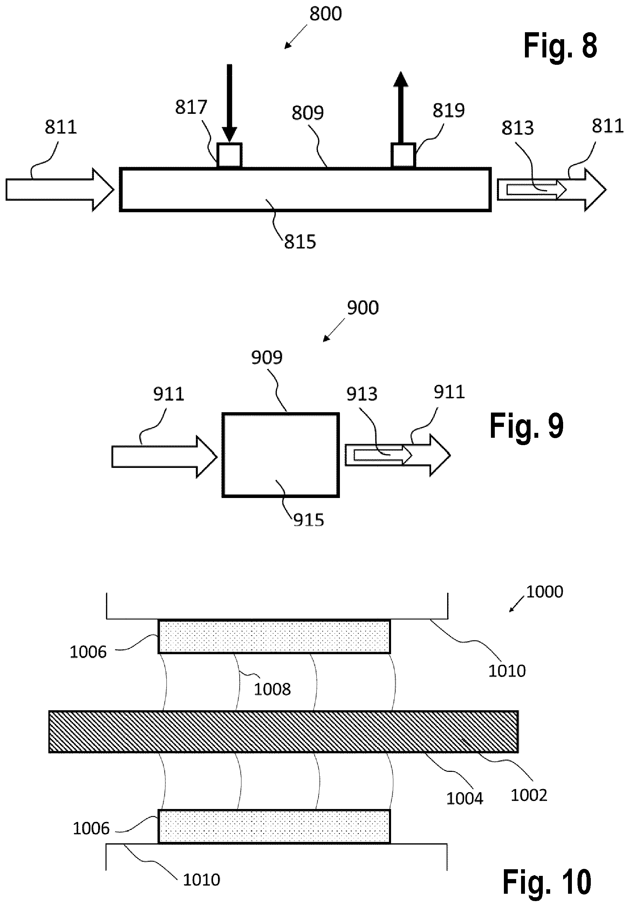

Gas target/medium HHG configurations may be broadly divided into three separate categories: gas jets, gas cell and gas capillaries. Figure 7 depicts an example gas jet configuration in which the gas medium is a gas flow introduced into a pump radiation. In the gas jet configuration, interaction of the pump radiation with solid parts is kept to a minimum. The gas volume may for example comprise a gas stream/flow perpendicular to the pump radiation beam, different from the gas medium with a fixed volume enclosed inside a gas cell with Figure 9 as one example. The capillary shown in Figure 8 is an object with a hollow core, and the hollow core has an elongated volume in an elongated direction through the object. The hollow core is for holding the gas medium and the interaction space is located inside the hollow core to generate the emitted radiation. The capillary may for example be a hollow-core fibre. The capillary may comprise an axial hollow core region and an inner cladding region comprising an arrangement of anti-resonant elements (AREs) surrounding the core region. The capillary may for example have a cross section which comprises one or more of the structures described in reference EP 3341771 A1, which is incorporated herein by reference in its entirety. A capillary may provide an increased interaction zone of the pump radiation and the gaseous medium, which may optimise the HHG process. On the other hand, a gas jet HHG configuration may offer a relative freedom to shape a spatial profile of the pump radiation beam in the far field, as it is not confined by the restrictions imposed by the capillary. Gas jet configurations may also have less stringent alignment tolerances.

Figure 8 shows a simplified schematic drawing of an embodiment 800 of an illumination source 310, which may be the illumination source for high harmonic generation (HHG). One or more of the features of the illumination source in the metrology tool described above, for example with respect to Figure 6, may also be present in the illumination source 800 as appropriate. The illumination source 800 may comprise a chamber as the chamber 601 in Figure 7, which is not shown here, and is configured to receive a pump radiation 811 with a propagation direction which is indicated by an arrow. The arrow also indicates the elongated direction of the elongated volume. The pump radiation 811 shown here may be an example of the pump radiation 340 from the pump radiation source 330, as shown in Figure 6. The pump radiation 811 may be directed into the chamber through a radiation input and further into a capillary 809, which is optionally a hollow-core fibre and optionally a thin quartz or glass capillary. In one embodiment, dimensions of the capillary 809 holding the gas medium may be small in the lateral direction such that it significantly influences the propagation of the pump radiation beam. In one embodiment, dimensions of the capillary 809 holding the gas medium are big enough in the lateral direction such that it will not influence the propagation of the pump radiation. The illumination source 800 further comprise a gas delivery system to provide the gas medium into the hollow core, which may be one example of the gas delivery system 332 mentioned above. The gas delivery system may comprise a gas inlet 817 and a gas outlet 819 for filling the capillary 809 with a gas medium which, in operation, may be a gas flow 815. In operation at least a portion of the gas flow 815 has a flow direction along at least a portion of the hollow core. Gas pressure of the gas flow 815 inside the capillary 809 may be optimized, optionally the gas pressure is above one atmosphere, optionally the gas pressure is above five atmospheres, optionally the gas pressure is above ten atmospheres. The gas flow 815 may comprise one or more of the following gases: air, Neon (Ne), Helium (He), Nitrogen (N₂), Oxygen (O₂), Argon (Ar), Krypton (Kr), Xenon (Xe), Carbon dioxide (CO₂) and the combination of two or more of them. Optionally the gas inlet 817 may comprise multiple gas inlets distributed at different locations optionally along the elongated direction to modify a profile of a density distribution of the gas flow 815. Optionally the gas outlet 819 may comprise multiple gas outlets to modify the profile of the density distribution of the gas flow 815. Optionally when there are multiple gas inlets, different gases may flow into the capillary 809 through different gas inlets to modify the profile and composition of the density distribution of the gas flow 815. The density distribution of the gas flow 815 may further influence the properties of the emitted radiation.

Due to interaction of the pump radiation 811 with the gas medium in the capillary 809, the gas medium will convert part of the pump radiation 811 into the emitted radiation 813 inside the hollow core of the capillary, optionally via a high harmonic generation process. The emitted radiation 813 may be an example of the emitted radiation 342 shown in Figure 6. The central axes of the emitted radiation 813 may be collinear with the central axes of the pump radiation 811. In Operation, the pump radiation 811 and the emitted radiation 813 propagate coaxially along an optical propagation direction and along at least a portion of the hollow core. The emitted radiation 813 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, optionally from 10 nm to 50 nm, or optionally from 10 nm to 20 nm.

Figure 9 shows a simplified schematic drawing of an embodiment 900 of an illumination source 310, which may be the illumination source for high harmonic generation (HHG). One or more of the features of the illumination source in the metrology tool described above, for example with respect to Figure 6 and Figure 8, may also be present in the illumination source 900 as appropriate. The pump radiation 911 and the emitted radiation 913 are the same as the pump radiation 811 and the emitted radiation 813 mentioned in the embodiment 800. In operation, the gas medium 915 may be static instead of a gas flow as in Figure 8. The gas cell 909 may be similar as the gas capillary 809 but without the gas inlet 817 and the gas outlet 819. In one embodiment, dimensions of the gas cell holding the gas medium may be small in the lateral direction such that it significantly influences the propagation of the pump radiation beam. In one embodiment, dimensions of the gas cell holding the gas medium are big enough in the lateral direction such that it will not influence the propagation of the pump radiation.

Gas filled capillaries and cells are efficient methods to create a high conversion efficiency (CE) since the gas pressure inside may be maintained at a higher level compared with the gas pressure of the gas flow in the gas nozzle mentioned above. However, power of the pump radiation which may be focused into the capillary or cell is limited by a maximum heat load that can be handled by the capillary or cell. Pump radiation with high input power would be required to produce required emitted radiation power for metrology measurement of HVM. In operation the power of the pump radiation may be above 30W, optionally above 50W, optionally above 100W, optionally above 200W, optionally above 300W, optionally above 500W, optionally above 1000W and optionally above 2000W. Increasing the power of the pump radiation would lead to damage and instability of the capillary or cell and therefore power of the emitted radiation may be limited. For example, when scaling up the pump radiation power in capillary beyond the above-mentioned values, thermal issues may become more and more dominant. Thermal expansion will cause the capillary to move, which will further change matching of the pump radiation to the capillary, i.e. alignment between the pump radiation and the capillary. The motion of the capillary may further change the power absorbed, i.e. more power of the pump radiation may be absorbed by the capillary, leading to more thermal expansion and motion. The above-mentioned thermal problem may not only trigger unwanted dynamics, but also reduce lifetime of the capillary.

These capillaries and cells may be made from fused quartz or glass to maximize the damage threshold due to the transparency for pump radiation wavelengths. But fused quartz and glass have relative low heat conductivities which make them difficult to cool the capillary or cell. Furthermore, in most applications the quartz capillary is supported by O-rings or adhesives that the capillary is isolated from surrounding environment especially in vacuum. O-ring materials include PTFE, Nitrile (Buna), Neoprene, EPDM Rubber and Fluorocarbon (Viton). In high temperature applications, Silicone and Kalrez^{®} O-ring materials are widely used. The adhesives include photopolymer and light-activated resin.

The features described in the following texts may be implemented to improve maximum power onto the capillary or cell to improve the power of the emitted radiation. These features may bring a higher thermal-mechanical stability. Although specific reference may be made to capillary, it should be noted that the features mentioned in these embodiments can also be implemented into the gas cell as shown in Figure 9.

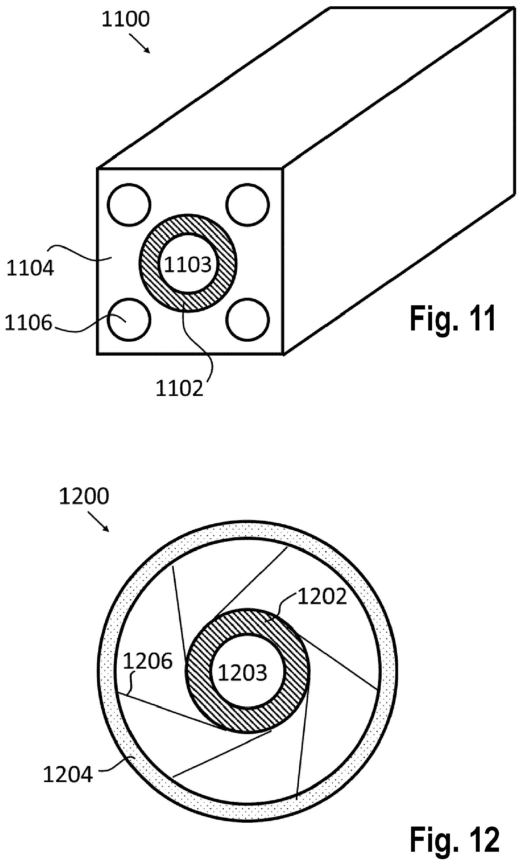

An example of a first embodiment 1000 is shown in Figure 10, viewed from a direction perpendicular to the elongated direction. A capillary 1002 shown here may be an example of the capillary 809 from the radiation source 800, as shown in Figure 8. The capillary 1002 is referred as 1102, 1202, and 1302 in Figures 11, 12 and 13 respectively. In one example, to transfer the heat generated at the interaction space, optionally during the high harmonic process, away from the capillary 1002, a heat conductive structure 1008 that connects at multiple locations of an outside wall of the capillary 1002. The heat conductive structure 1008 may have elongated shape, and optionally comprises at least one of wires, braids, fins and springs. In one example, at least part of the outside wall of the capillary 1002 comprises a heat conductive outside surface 1004. The heat conductive outside surface 1004 may comprise at least one of a coating, layer, tube and block and may have a matching coefficient of thermal expansion with the capillary. The heat conductive structure 1008 may be brazed onto the outside wall of the capillary and/or on the heat conductive outside surface 1004. In one example, the first embodiment 1000 further comprises one or more heat sink 1006, and the heat conductive structure 1004 is connected to the heat sink 1006 and transfers the heat away from the capillary 1002 to the heat sink 1006. The heat sink 1006 may be further cooled by cooling liquid or one or more cooled surfaces 1010. The cooled surfaces 1010 are optionally cooling-liquid-cooled optionally water-cooled surfaces. Distance between the capillary 1002 and the heat sink 1006 may be kept short, to gain a high cooling capacity in combination with a high stability. The heat conductive outside surface 1004 and the heat conductive structure 1008 may be of the same or different materials with high thermal conductivities, comprising one or more of Tin, Gold, Copper, Aluminum, Silicon carbide (SiC), Beryllium oxide (BeO), Tungsten, Zinc, Graphite and Silver. Optionally the heat conductive outside surface 1004 comprise artificial diamond or any other diamond-like materials with good thermal conductivities. The diamond-like materials are materials displaying some of the typical properties of diamond such as low friction, high hardness, high corrosion resistance and good transmission in the infrared, one example of which is a diamond-like carbon. In Figure 10, there are two heat sinks with cooled surfaces 1010 at the opposite sides of the capillary 1002, while in reality there may be other number of heat sinks distributed at any locations with respect to the capillary 1002. Optionally the heat conductive structure 1008 are distribute evenly along the capillary direction and/or evenly around the capillary 1002.

In one example, when the pump radiation travels through the elongated volume of the capillary, it may induce current on the heat conductive structure 1008 which may cause power attenuation in the interaction space. For embodiments comprising the heat conductive outside surface 1004, the power attenuation may also occur due to the induced current on the heat conductive outside surface. Therefore the heat conductive outside surface 1004 and/or the heat conductive structure 1008 may be placed further away from the interaction space. To find a sweet point between low the power attenuation and high thermal conductivity, a total contact area between the heat conductive outside surface and/or the heat conductive structure and the capillary is less than 75%, optionally less than 50%, optionally less than 10% and optionally less than 5% of total area of outside wall of the capillary.

An example of a second embodiment 1100 is shown in Figure 11. One or more of the features of the first embodiment 1000 described with respect to Figure 10, may also be present in the second embodiment 1100 as appropriate. At least part of the capillary 1102, with a hollow core 1103, is placed inside a tube 1104, optionally a metal tube. The tube 1104 may be considered as one example of the heat conductive outside surface 1004. In one example, the tube 1104 may comprise one or more materials with high thermal conductivities. For example the tube 1104 may comprise one or more of Tin, Gold, Copper, Aluminum, Silicon carbide (SiC), Beryllium oxide (BeO), Tungsten, Zinc, Graphite and Silver. In one example, the tube 1104 may have matching coefficient of thermal expansion (CTE) with the capillary 1102 and high thermal conductivity. Matching CTE is to prevent capillary cracks and to have a thermal-mechanical stable system. For example, a tube comprising Molybdenum Copper alloy (MoCu) may have a matching CTE with the capillary 1102. The tube 1104 may comprise cooling lines 1106, optionally water-cooling lines, optionally along the elongated direction. The tube 1104 may be connected to the capillary 1102 by multiple connections as discussed in the first embodiment 1000 or by use of a liquid metal. When the liquid metal is used as the connection, the CTE matching between the capillary and the tube is not necessary. In the example shown in Figure 11, there are four cooling lines distributed at four corners of the cross section of the capillary, while in reality there may be other number of cooling lines distributed around the capillary optionally with rotationally/radial symmetry.

An example of a third embodiment 1200 is shown in Figure 12, viewed along the elongated direction. One or more of the features of the first embodiment 1000 and second embodiment 1100 described with respect to Figures 10 and 11, may also be present in the third embodiment 1200 as appropriate. The capillary 1202 with a hollow core 1203 is brazed or clamping into a spring nest 1206, optionally a metal spring next. The spring nest 1206 may serve as one example of the heat conductive structure 1008 as discussed in the first embodiment 1000. Optionally the spring nest 1206 connects the capillary 1202 to a spring nest holder 1204 to transfer heat away from the capillary to the spring nest holder 1204. The spring nest holder may be one example of the heat sink 1006 discussed above. The spring nest holder 1204 may be cooled, for example by water, and may hold the capillary 1202 in its thermal center. The spring nest holder 1204 may have matching coefficient of thermal expansion (CTE) with the capillary 1202 and high thermal conductivity to prevent capillary cracks and to have a thermal-mechanical stable system. For example, the spring nest holder 1204 comprising Molybdenum Copper alloy (MoCu) may have a matching CTE with the capillary 1202. The spring nest holder 1204 may have cooling lines, optionally water-cooling lines. For example, the spring nest holder 1204 may comprise one or more of Tin, Gold, Copper, Aluminum, Silicon carbide (SiC), Beryllium oxide (BeO), Tungsten, Zinc, Graphite and Silver.

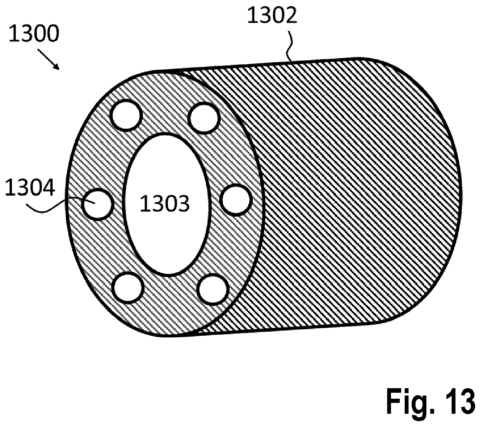

An example of a fourth embodiment 1300 is shown in Figure 13. One or more of the features of the first embodiment 1000, second embodiment 1100 and third embodiment 1200 described with respect to Figures 10, 11 and 12, may also be present in the fourth embodiment 1300 as appropriate. The capillary 1302, with a hollow core 1303, has one or more cooling lines 1304, optionally water-cooling lines. Different from the cooling lines in the embodiments mentioned above, the cooling lines in Figure 13 are integrated inside tube wall of the capillary 1302. The cooling lines transfer the heat from the capillary to other components.

For the embodiments mentioned above, the capillary 809, 1002, 1102, 1202, and 1302 may comprise one or more materials of glass, quartz, crystalline Aluminium Oxide AlO₂, Sapphire, Silicon Carbide SiC or Silicon Nitride Si₃N₄. Optionally the capillary is a metal fiber, optionally a hollow-core metal fiber, with polished inside wall. The capillary may be manufactured with 3D printing. For the embodiments mentioned above, the tube wall of the capillary 809, 1002, 1102, 1202, and 1302 may comprise multiple layers with different materials listed above.

To get a high-power emitted radiation, it is important that the capillary is aligned with the pump radiation, and remains stable, which enhances the CE and prevents damage by high power of the pump radiation. In order to have a capillary with high stability, it may be important that the materials and/or design of the capillary are such that they have a high thermal conductivity and low CTE.

The embodiments may enable a capillary with better heat conductivity, which may shorten stabilization time during metrology measurement. This invention may enable emitted radiation with higher power, which may improve metrology measurement throughput.

Although specific reference may have been made to illumination source comprising capillary or gas cell, it will be appreciated that the invention, where the context allows, may be used in other sources. For example, some features of the above-mentioned embodiments may be applied in a Laser Pumped Plasma Source (LPPS) with a container, for example a glass capsule, containing a predetermined gaseous atmosphere, as described in US9357626B2 to improve thermal conductivity of the container. For example, some features of the above-mentioned embodiments may be applied in a broadband light source with an optical fiber, for example a hollow-core optical fiber, as described in WO2021037472A1 to improve thermal conductivity of the optical fiber.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. An assembly for receiving a pump radiation to interact with a gas medium at an interaction space to generate an emitted radiation, the assembly comprising:
   an object with a hollow core,
      wherein the hollow core has an elongated volume through the object,
      wherein the interaction space is located inside the hollow core,
   and a heat conductive structure that connects at multiple locations of an outside wall of the object for transferring heat generated at the interaction space away from the object.
2. An assembly according to clause 1, wherein the assembly is configured for high harmonic generation process, wherein optionally the gas medium is selected such that the emitted radiation is generated via high harmonic generation process, and wherein optionally the pump radiation is selected such that the emitted radiation is generated via high harmonic generation process.
3. An assembly according to any of the preceding clauses, wherein in operation power of the pump radiation is above 30W, optionally above 50W, optionally above 100W, optionally above 200W, optionally above 300W, optionally above 500W, optionally above 1000W and optionally above 2000W.
4. An assembly according to any of the preceding clauses, wherein in operation the gas medium is a gas flow.
5. An assembly according to clause 4, wherein in operation at least a portion of the gas flow has a flow direction along at least a portion of the hollow core.
6. An assembly according to any of the preceding clauses, wherein the heat conductive structure has elongated shape, optionally the heat conductive structure comprises at least one of wires, braids, fins and springs.
7. An assembly according to any of the preceding clauses, wherein the heat conductive structure comprises at least one of Tin, Gold, Copper, Aluminum, Silicon carbide, Beryllium oxide, Tungsten, Zinc, Graphite and Silver.
8. An assembly according to any of the preceding clauses, wherein the object comprises a heat conductive outside surface being in contact with the heat conductive structure at the multiple locations, optionally the heat conductive outside surface comprises at least one of a coating, layer, tube and block.
9. An assembly according to clause 8, wherein the heat conductive outside surface comprise at least one of Tin, Gold, Copper, Aluminum, Silicon carbide, Beryllium oxide, Tungsten, Zinc, Graphite, Silver, artificial diamond and any other diamond-like materials.
10. An assembly according to clause 8 or 9, wherein a total contact area between heat conductive outside surface and the object is less than 75%, optionally less than 50%, optionally less than 10% and optionally less than 5% of total area of the outside wall of the object.
11. An assembly according to any of clauses 8 to 10, wherein the heat conductive outside surface has a matching coefficient of thermal expansion with the object.
12. An assembly according to any of the preceding clauses, wherein a total contact area between the heat conductive structure and the object is less than 75%, optionally less than 50%, optionally less than 10% and optionally less than 5% of total area of the outside wall of the object.
13. An assembly according to any of the preceding clauses, wherein the assembly further comprises a heat sink, wherein the heat conductive structure is connected to the heat sink and transfers the heat away from the object to the heat sink.
14. An assembly according to any of the preceding clauses, wherein the pump radiation and the emitted radiation have non-overlapping wavelengths.
15. An assembly according to any of the preceding clauses, wherein the gas medium comprises at least one of air, Neon (Ne), Helium (He), Nitrogen (N₂), Oxygen (O₂), Argon (Ar), Krypton (Kr), Xenon (Xe), and Carbon dioxide (CO₂).
16. An assembly according to any of the preceding clauses, wherein the emitted radiation comprises radiation with one or more wavelengths in a range from 1 nm to 50 nm, optionally from 10 nm to 50 nm and optionally from 10 nm to 20 nm.
17. An assembly according to any of the preceding clauses, wherein the pump radiation comprises radiation with one or more wavelengths in a range of 200 nm to 10 µm, optionally 500 nm to 2000 nm, optionally 800 nm to 1500 nm.
18. An assembly according to any of the preceding clauses, wherein in operation the pump radiation and the emitted radiation propagate coaxially along an optical propagation direction and along at least a portion of the hollow core.
19. An assembly according to any of the preceding clauses, wherein the assembly comprises a gas delivery system to provide the gas medium into the hollow core.
20. A radiation source comprising an assembly according to any of the preceding clauses.
21. A lithographic apparatus comprising a radiation source according to clause 20.
22. A metrology apparatus comprising a radiation source according to clause 20.
23. A lithographic cell comprising a radiation source according to clause 20.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus /tool/ system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

## Claims

1. An assembly for receiving a pump radiation to interact with a gas medium at an interaction space to generate an emitted radiation, the assembly comprising:
an object with a hollow core,
wherein the hollow core has an elongated volume through the object,
wherein the interaction space is located inside the hollow core,
and a heat conductive structure that connects at multiple locations of an outside wall of the object for transferring heat generated at the interaction space away from the object.

2. An assembly according to claim 1, wherein the assembly is configured for high harmonic generation process, wherein optionally the gas medium is selected such that the emitted radiation is generated via high harmonic generation process, and wherein optionally the pump radiation is selected such that the emitted radiation is generated via high harmonic generation process.

3. An assembly according to any of the preceding claims, wherein in operation power of the pump radiation is above 30W, optionally above 50W, optionally above 100W, optionally above 200W, optionally above 300W, optionally above 500W, optionally above 1000W and optionally above 2000W.

4. An assembly according to any of the preceding claims, wherein in operation the gas medium is a gas flow.

5. An assembly according to claim 4, wherein in operation at least a portion of the gas flow has a flow direction along at least a portion of the hollow core.

6. An assembly according to any of the preceding claims, wherein the heat conductive structure has elongated shape, optionally the heat conductive structure comprises at least one of wires, braids, fins and springs.

7. An assembly according to any of the preceding claims, wherein the heat conductive structure comprises at least one of Tin, Gold, Copper, Aluminum, Silicon carbide, Beryllium oxide, Tungsten, Zinc, Graphite and Silver.

8. An assembly according to any of the preceding claims, wherein the object comprises a heat conductive outside surface being in contact with the heat conductive structure at the multiple locations, optionally the heat conductive outside surface comprises at least one of a coating, layer, tube and block.

9. An assembly according to claim 8, wherein the heat conductive outside surface comprise at least one of Tin, Gold, Copper, Aluminum, Silicon carbide, Beryllium oxide, Tungsten, Zinc, Graphite, Silver, artificial diamond and any other diamond-like materials.

10. An assembly according to claim 8 or 9, wherein a total contact area between heat conductive outside surface and the object is less than 75%, optionally less than 50%, optionally less than 10% and optionally less than 5% of total area of the outside wall of the object.

11. An assembly according to any of claims 8 to 10, wherein the heat conductive outside surface has a matching coefficient of thermal expansion with the object.

12. An assembly according to any of the preceding claims, wherein a total contact area between the heat conductive structure and the object is less than 75%, optionally less than 50%, optionally less than 10% and optionally less than 5% of total area of the outside wall of the object.

13. An assembly according to any of the preceding claims, wherein the pump radiation and the emitted radiation have non-overlapping wavelengths.

14. An assembly according to any of the preceding claims, wherein in operation the pump radiation and the emitted radiation propagate coaxially along an optical propagation direction and along at least a portion of the hollow core.

15. A radiation source comprising an assembly according to any of the preceding claims.
